# EUROPEAN PATENT APPLICATION

(11) **EP 1 562 236 A2**
(43) Date of publication of application: **10.08.2005**
(21) Application number: 04256921.0
(22) Date of filing: 09.11.2004
(51) Int. Cl.: H01L 29/45, H01L 21/285, H01L 33/00

(54) **Transparent electrode layer, semiconductor light emitting device including the same, and method of forming the transparent electrode layer**

(30) Priority: 04.02.2004 KR 2004007233; 28.08.2004 KR 2004068295
(71) Applicant: Samsung Electro-Mechanics Co., Ltd., Suwon-si, Gyunggi-do (KR); Gwangju Institute of Science and Technology, Buk-gu, Gwangju-si (KR)
(72) Inventor: Kwak, Joon-seop, Taean-eub, Hwaseong-ri, Gyeonggi-do (KR); Seong, Tae-yeon, Gwangju Inst. of Science and T., Gwangju-si (KR); Nam, Ok-hyun, Gangnam-gu, Seoul (KR); Song, June-o, Gwangju Inst. of Science and Techn., Gwangju-si (KR)
(74) Representative: Greene, Simon Kenneth

(57) **Abstract**

Provided are an electrode structure, a light emitting device including the electrode layer, and a method of forming the electrode layer. The electrode layer includes a first electrode layer and a second electrode layer, which are sequentially stacked, and the first electrode layer is formed of indium oxide added by an additive element. Also, the additive element includes at least one selected from the group consisting of Mg, Ag, Zn, Sc, Hf, Zr, Te, Se, Ta, W, Nb, Cu, Si, Ni, Co, Mo, Cr, Mn, Hg, Pr, and La.

## Description

The present invention relates to a predetermined material layer, a method of forming the same, and a light emitting device including the same, and more particularly, to an electrode layer, a method of forming the electrode layer, and a light emitting device including the electrode layer.

It is preferable that a light emitting device, such as a light emitting diode (LED) or a laser diode (LD), require a low drive voltage and exhibit a high luminous efficiency at a low drive voltage.

To reduce a drive voltage, a light emitting device in which a material layer is disposed in an improved manner between an electrode layer and an active layer is widely used. In the light emitting device of this structure, a width of a current inflow path ranging from the electrode layer to the active layer is limited such that light is emitted in a limited region.

To further lower the drive voltage of the light emitting device, it is most important to reduce not only a resistance of the electrode layer but also a resistance of the material layer formed between the electrode layer and the active layer.

In particular, since the electrode layer is a material layer through which a current for light emission firstly passes and in ohmic contact with a compound semiconductor layer, for example, a p-type GaN compound semiconductor layer, it is essential to reduce the resistance of the electrode layer to lower the drive voltage of the light emitting device.

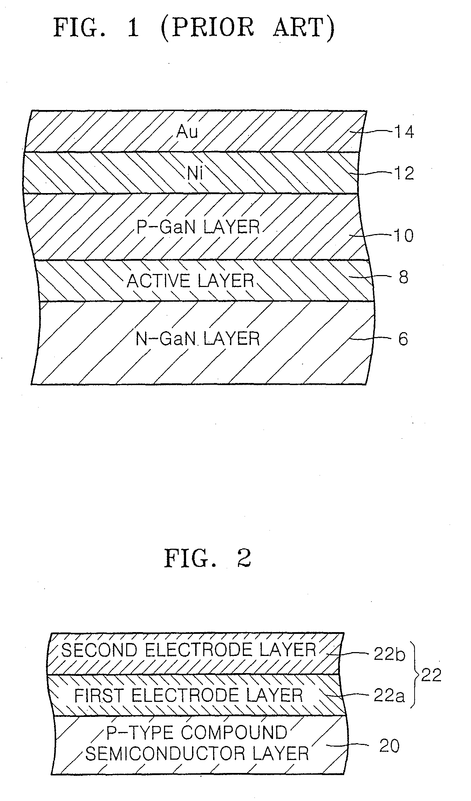

FIG. 1 is a cross-sectional view of a light emitting device including a conventional electrode layer.

Referring to FIG. 1, the light emitting device includes an n-GaN layer 6, an active layer 8, and a p-GaN layer 10, which are sequentially stacked, and a p-type electrode is formed on the p-GaN layer 10. The p-type electrode includes a first electrode layer 12 and a second electrode layer 14, which are sequentially formed. The first electrode layer 12 is formed of Ni, and the second electrode layer 14 is formed of Au.

In this conventional light emitting device, since the p-type electrode is formed in a thermodynamic relationship with the first and second electrode layers 12 and 14, the p-type electrode may be formed of only several predetermined materials.

Also, when the p-type electrode is formed of a Ni layer and an Au layer, the p-type electrode may have a high resistance and a low transmissivity. Thus, use of this p-type electrode may be limited.

According to an aspect of the present invention, there is provided an electrode structure or layer including a first electrode layer and a second electrode layer, which are sequentially stacked. The first electrode layer is formed of indium oxide added by an additive element.

The additive element may include at least one selected from the group consisting of Mg, Ag, Zn, Sc, Hf, Zr, Te, Se, Ta, W, Nb, Cu, Si, Ni, Co, Mo, Cr, Mn, Hg, Pr, and La.

An addition ratio of the additive element to the indium oxide may be in the range of 0.001 to 49 atomic percent.

The thickness of the first electrode layer may be in the range of 0.1 to 500 nm.

The second electrode layer may be a metal layer or a transparent conductive oxide (TCO) layer. The metal layer may be formed of Au, Pd, Pt, or Ru. The TCO layer may be formed of indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), In₄Sn₃O₁₂, or zinc magnesium oxide (Zn₁₋ₓMgₓO, 0 ≤ x ≤ 1).

The thickness of the second electrode layer may be in the range of 0.1 to 500 nm.

According to another aspect of the present invention, there is provided a light emitting device comprising at least an n-type compound semiconductor layer, an active layer, and a p-type compound semiconductor layer, which are disposed between an n-type electrode layer and a p-type electrode layer. The p-type electrode layer includes a first electrode layer and a second electrode layer, which are sequentially stacked, and the first electrode layer is formed of indium oxide added by an additive element.

According to yet another aspect of the present invention, there is provided a method of forming an electrode layer. The method comprises forming a first electrode layer on a substrate; forming a second electrode layer on the first electrode layer; and annealing the resultant structure where the second electrode layer is formed. Herein, the first electrode layer is formed of indium oxide added by an additive element.

The resultant structure may be annealed in an atmosphere including at least one selected from the group consisting of N, Ar, He, O, H, and air at a temperature of about 200 to 700 °C for 10 seconds to 2 hours.

The first electrode layer and the second electrode layer may be formd using an e-beam & thermal evaporator.

An electrode structure according to the present invention has a low resistance and a high transmissivity.

Therefore, when the electrode structure or layer is used for a light emitting device, the light emitting device can require only a low drive voltage and have a high transmissivity, thereby greatly improving a luminous efficiency.

The present invention provides an electrode structure having a relatively low resistance and a high transmissivity.

The present invention also provides a light emitting device including the electrode layer.

The present invention further provides a method of forming the electrode layer.

The above features and advantages of the present invention will become more apparent by describing in detail exemplary embodiments thereof with reference to the attached drawings in which:
FIG. 1 is a cross-sectional view of a light emitting device including a conventional electrode layer;
FIG. 2 is a cross-sectional view of an electrode layer according to the present invention;
FIG. 3A is a graph showing a measurement result of a current-voltage (C-V) characteristic of an electrode layer (MIO/Au) according to a first embodiment of the present invention;
FIG. 3B is a graph showing a measurement result of a drive voltage of an InGaN blue light emitting diode (LED) including the electrode layer of FIG. 3A;
FIG. 4A is a graph showing a measurement result of a C-V characteristic of an electrode layer (CIO/ZITO) according to a second embodiment of the present invention;
FIG. 4B is a graph showing a measurement result of a drive voltage of an InGaN blue LED including the electrode layer of FIG. 4A;
FIG. 5A is a graph showing a measurement result of a C-V characteristic of an electrode layer (CIO/ITO) according to a third embodiment of the present invention;
FIG. 5B is a graph showing a measurement result of a drive voltage of an InGaN blue LED including the electrode layer of FIG. 5A;
FIG. 6 is a graph showing a measurement result of a C-V characteristic of an electrode layer (MIO/ITO) according to a fourth embodiment of the present invention;
FIG. 7 is a graph showing a measurement result of a C-V characteristic of an electrode layer (CIO/Au) according to a fifth embodiment of the present invention;
FIGS. 8 and 9 are cross-sectional views illustrating light emitting devices including the electrode layers according to the present invention; and
FIG. 10 illustrates a method of forming an electrode layer according to the present invention.

The present invention will now be described more fully with reference to the accompanying drawings, in which exemplary embodiments of the invention are shown.

At the outset, an electrode structure according to an embodiment will be described.

FIG. 2 is a cross-sectional view of an electrode structure according to the present invention.

Referring to FIG. 2, the p-type electrode 22 is disposed on a p-type compound semiconductor layer 20. The p-type electrode 22 includes a first electrode layer 22a and a second electrode layer 22b, which are sequentially stacked. The first electrode layer 22a is formed of indium oxide, such as In₂O₃, which is added by an additive element.

The additive element may improve an ohmic characteristic of the first electrode layer 22a by adjusting characteristics of indium oxide, such as band gap, electron affinity, and work function.

The additive element can be a metal material, which increases an effective carrier concentration of the p-type compound semiconductor layer 20 and readily reacts with elements constituting the p-type compound semiconductor layer 20 except nitrogen.

For example, when the p-type compound semiconductor layer 20 is formed of a GaN-based compound, the additive element may be an element that reacts to Ga prior to N.

Thus, Ga of the p-type compound semiconductor layer 20 reacts to the first electrode layer 22a, thus generating Ga vacancies in the surface of the p-type compound semiconductor layer 20. As the Ga vacancies function as a p-type dopant, an effective concentration of p-type carriers in the surface of p-type compound semiconductor layer 20 increases.

The first electrode layer 22a may be formed of a material, which reacts to a Ga₂O₃ layer, which is a native oxide layer that remains on the p-type compound semiconductor layer 20 during formation of the first electrode layer 22a, to generate transparent conductive oxide. The Ga₂O₃ layer serves as a barrier to flow of carriers at an interface between the p-type compound semiconductor layer 20 and the first electrode layer 22a. In this case, a tunneling conduction phenomenon may occur at the interface between the first electrode layer 22a and the p-type compound semiconductor layer 20, thus improving the ohmic characteristic of the first electrode layer 22a.

The additive element for the first electrode layer 22a may be at least one of Mg, Ag, Zn, Sc, Hf, Zr, Te, Se, Ta, W, Nb, Cu, Si, Ni, Co, Mo, Cr, Mn, Hg, Pr, and La.

Preferably, an addition ratio of the additive element to indium oxide is in the range of 0.001 to 49 atomic percent.

When the first electrode layer 22a is formed of indium oxide, the thickness of the first electrode layer 22a is in the range of 0.1 to 500 nm. The second electrode layer 22b is a metal layer or a transparent conductive oxide (TCO) layer. Here, the metal layer may be formed of Au, Pd, Pt, or Ru. The TCO layer may be formed of indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), In₄Sn₃O₁₂, or zinc magnesium oxide (Zn₁₋ₓMgₓO, 0 ≤ x ≤ 1). The oxide layer may be, for example, a Zn₂ln₂O₅ layer, a GalnO₃ layer, a ZnSnO₃ layer, an F-doped SnO₂ layer, an Al-doped ZnO layer, a Ga-doped ZnO layer, a MgO layer, or a ZnO layer. The thickness of the second electrode layer 22b is in the range of 0.1 to 500 nm.

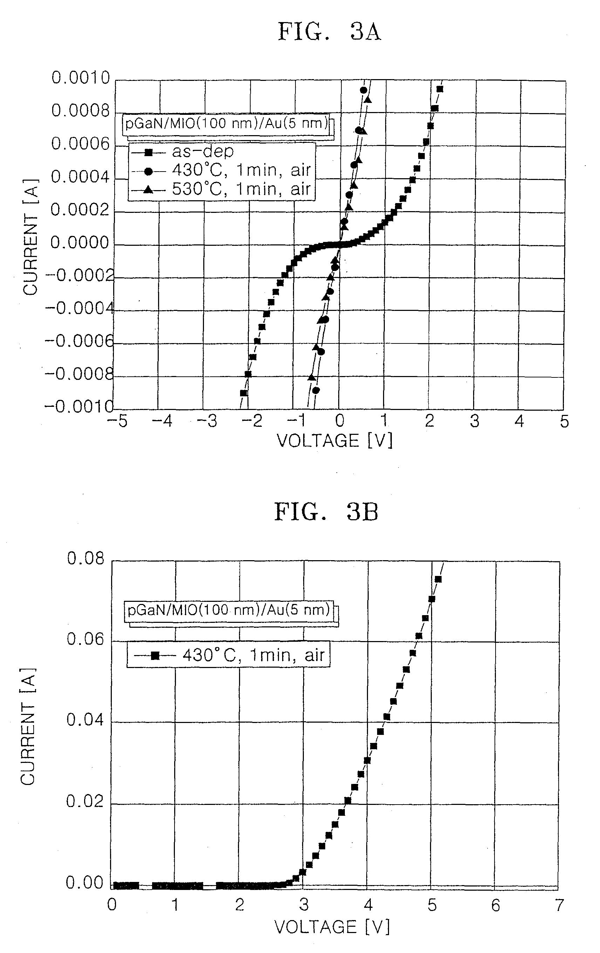

FIG. 3A is a graph showing a measurement result of a current-voltage (C-V) characteristic of an electrode layer (MIO/Au) according to a first embodiment of the present invention.

In the present embodiment, the electrode layer includes a first electrode layer 22a formed of magnesium-doped indium oxide (MIO) and a second electrode layer 22b formed of Au disposed on the first electrode layer 22a. The first electrode layer 22a and the second electrode layer 22b were formed to a thickness of about 100 nm and 5 nm, respectively.

To measure the resistance and voltage characteristic of the electrode layer of the present invention, the inventors formed a first electrode layer 22a on a p-type GaN layer to a thickness of 100 nm and then formed a second electrode layer 22b on the first electrode layer 22a to a thickness of 5 nm.

To be more specific, the first electrode layer 22a was formed using MIO obtained by adding Mg, which is one of the enumerated additive elements, to indium oxide on the p-type GaN layer 20, which includes GaN having a carrier concentration of 4 - 5×10¹⁷ cm⁻³ as a main element. The second electrode layer 22b was deposited using Au on the first electrode layer 22a. Thereafter, the inventors measured the electrical characteristic of the resultant structure where the first and second electrode layers 22a and 22b are formed. The electrical characteristic of the electrode layer (MIO/Au) was measured before an annealing process (i.e., as deposited) and after the electrode layer was annealed at 430°C and 530°C, respectively, in an air atmosphere for 1 minute each time. FIG. 3A shows a measurement result of the electrical characteristic of the electrode layer (MIO/Au). Referring to FIG. 3A, as annealing temperature increased, a slope of voltage-current (V-C) curve increased, i.e., resistance decreased. After the annealing process was performed at 430°C, a slope of the V-C curve was the highest.

As can be seen from FIG. 3A, before the annealing process was performed, a nonlinear C-V characteristic, i.e., a rectifying characteristic, was revealed, while after the annealing process was performed, a linear C-V characteristic including information on ohmic contact was exhibited. Also, it can be seen that noncontact resistance was in a low range of 10⁻³ to 10⁻⁵ Ωcm².

Meanwhile, indium oxide that is doped with or mixed with a predetermined element in order to control a band gap, an electron affinity, and a work function, which determine the electrical characteristic of the first electrode layer 22a being in contact with the p-type compound semiconductor layer 20, should have excellent optical transmissivity and conductivity. The first electrode layer 22a, which is formed of this indium oxide, reacts with Ga₂O₃, which is an oxide layer disposed on the p-type compound semiconductor layer 20, during the annealing process, thus generating a TCO layer, i.e., a GalnO₃ layer. As a result, Ga vacancies are formed in the surface of the p-type compound semiconductor layer 20, thereby increasing an effective concentration of holes around the surface of the p-type compound semiconductor layer 20. Since the GalnO₃ layer has a large work function, when contacting the p-type compound semiconductor layer 20, the GalnO₃ layer can reduce the height and width of a Schottky barrier, thereby improving an ohmic contact characteristic and optical transmissivity.

FIG. 3B is a graph showing a measurement result of a drive voltage of an InGaN blue light emitting diode (LED) including the electrode layer of FIG. 3A.

The electrode layer (MIO/Au) was annealed at a temperature of 430 °C in an air atmosphere for 1 minute. Referring to FIG. 3B, the blue LED including the electrode layer (MIO/Au) as a p-type electrode layer has an improved drive voltage characteristic.

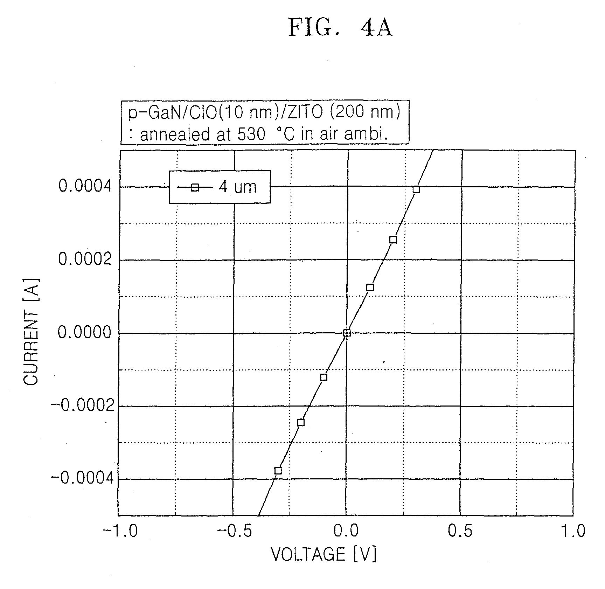

FIG. 4A is a graph showing a measurement result of a C-V characteristic of an electrode layer (CIO/ZITO) according to a second embodiment of the present invention.

In the present embodiment, the electrode layer (CIO/ZITO) includes a first electrode layer formed of copper-doped indium oxide (CIO) and a second electrode layer formed of ZITO disposed on the first electrode layer. The first electrode layer and the second electrode layer were formed to a thickness of 10 nm and 200 nm, respectively. Also, the electrode layer (CIO/ZITO) was annealed at a temperature of about 530 °C in an air atmosphere for 1 minute.

As can be seen from FIG. 4A, the electrode layer (CIO/ZITO) had a nonlinear C-V characteristic and a low noncontact resistance of 10⁻³ to 10⁻⁵ Ωcm². Here, when the C-V characteristic of the electrode layer was measured, a distance between adjacent electrodes was 4 µm.

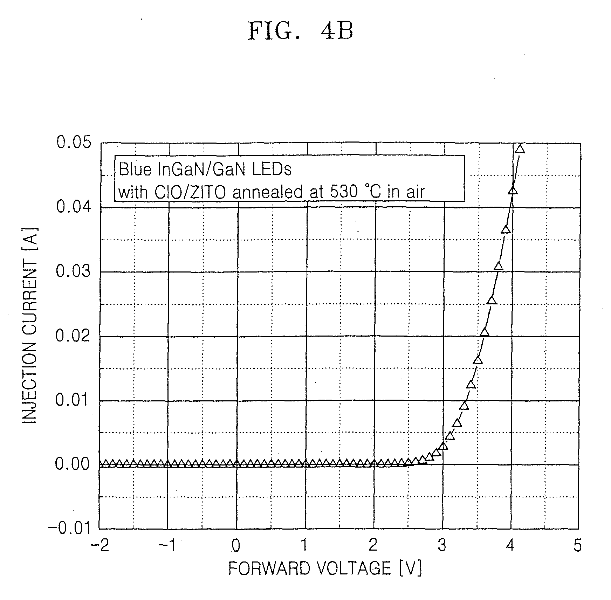

FIG. 4B is a graph showing a measurement result of a drive voltage of an InGaN blue LED including the electrode layer of FIG. 4A.

Referring to FIG. 4B, the blue LED including the electrode layer (CIO/ZITO) as a p-type electrode layer has an improved drive voltage characteristic.

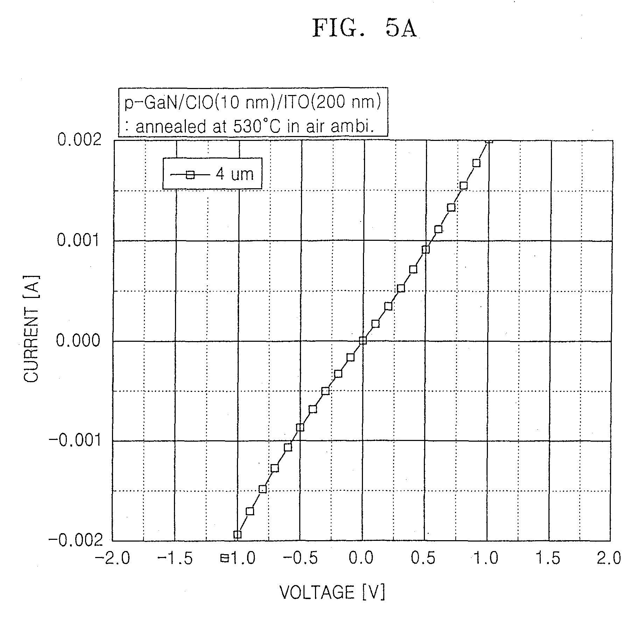

FIG. 5A is a graph showing a measurement result of a C-V characteristic of an electrode layer (CIO/ITO) according to a third embodiment of the present invention.

In the present embodiment, the electrode layer (CIO/ITO) includes a first electrode layer formed of CIO and a second electrode layer formed of ITO disposed on the first electrode layer. The first electrode layer and the second electrode layer were formed to a thickness of about 10 nm and 200 nm, respectively. Also, the electrode layer (CIO/ITO) was annealed at a temperature of about 530 °C in an air atmosphere for 1 minute.

As can be seen from FIG. 5A, the electrode layer (CIO/ITO) had a nonlinear C-V characteristic and a low noncontact resistance of 10⁻³ to 10⁻⁵ Ωcm². Here, when the C-V characteristic of the electrode layer was measured, a distance between adjacent electrodes was 4 µm.

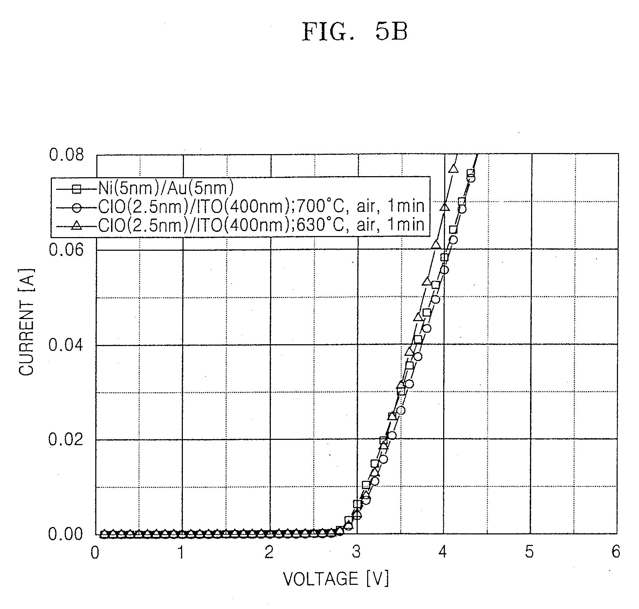

FIG. 5B is a graph showing a measurement result of a drive voltage of an InGaN blue LED including an electrode layer (CIO/ITO) formed according to the third embodiment of the present invention.

In this case, a first electrode layer and a second electrode layer were formed to a thickness of about 2.5 nm and 400 nm, respectively. A drive voltage of the blue LED including the electrode layer (CIO/ITO) was measured when the electrode layer was annealed at a temperature of 630 °C and 700 °C, respectively, in an air atmosphere for 1 minute each time, and compared with a drive voltage of an InGaN blue LED including a conventional electrode layer (Ni/Au).

Referring to FIG. 5B, the blue LED including the electrode layer (CIO/ITO) as a p-type electrode layer has an improved drive voltage characteristic.

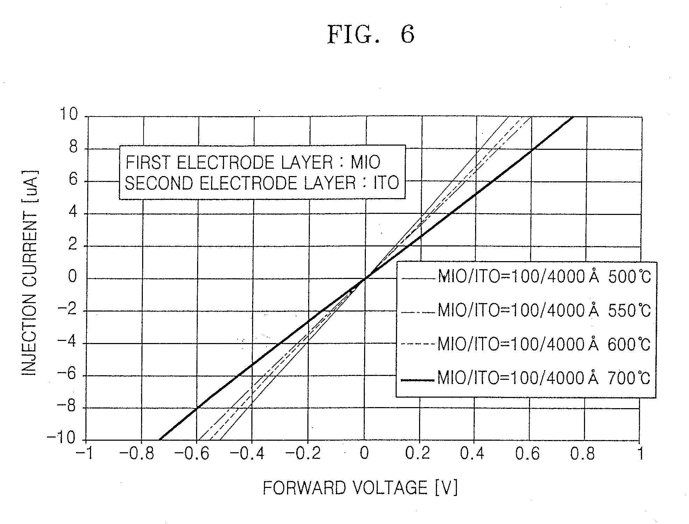

FIG. 6 is a graph showing a measurement result of a C-V characteristic of an electrode layer (MIO/ITO) according to a fourth embodiment of the present invention.

In the present embodiment, the electrode layer (MIO/ITO) includes a first electrode layer formed of MIO and a second electrode layer formed of ITO disposed on the first electrode layer. The first electrode layer and the second electrode layer were formed to a thickness of about 10 nm and 400 nm, respectively. The electrical characteristics of the electrode layer (MIO/ITO) were measured when it was annealed at a temperature of 500 °C, 550 °C, 600 °C, and 700 °C, respectively, in an air atmosphere for 1 minute each time.

As can be seen from FIG. 6, the electrode layer (MIO/ITO) had a linear C-V characteristic and a low noncontact resistance of 10⁻³ to 10⁻⁵ Ωcm². Here, when the C-V characteristic of the electrode layer was measured, a distance between adjacent electrodes was 4 µm.

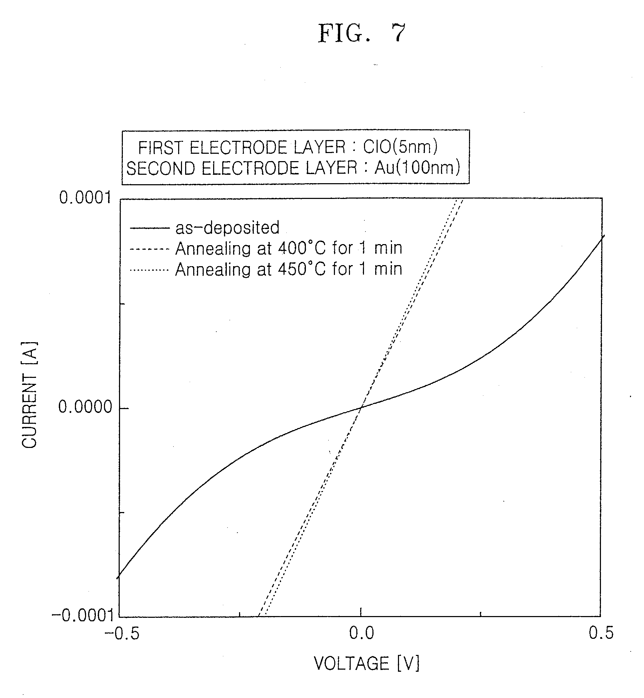

FIG. 7 is a graph showing a measurement result of a C-V characteristic of an electrode layer (CIO/Au) formed according to a fifth embodiment of the present invention.

In the present embodiment, the electrode layer (CIO/Au) includes a first electrode layer formed of CIO and a second electrode layer formed of Au disposed on the first electrode layer. The first electrode layer and the second electrode layer were formed to a thickness of about 5 nm and 100 nm, respectively. The electrical characteristics of the electrode layer (CIO/Au) were measured before an annealing process (i.e., as deposited) and after the electrode layer was annealed at 400°C and 450°C, respectively, in an air atmosphere for 1 minute each time.

As can be seen from FIG. 7, the electrode layer (CIO/Au) had a linear C-V characteristic and a low noncontact resistance of 10⁻³ to 10⁻⁵ Ωcm². Here, when the C-V characteristic of the electrode layer was measured, a distance between adjacent electrodes was 4 µm.

Hereinafter, an LED and a laser diode (LD), which are examples of a light emitting device including the foregoing electrode layer, will be described.

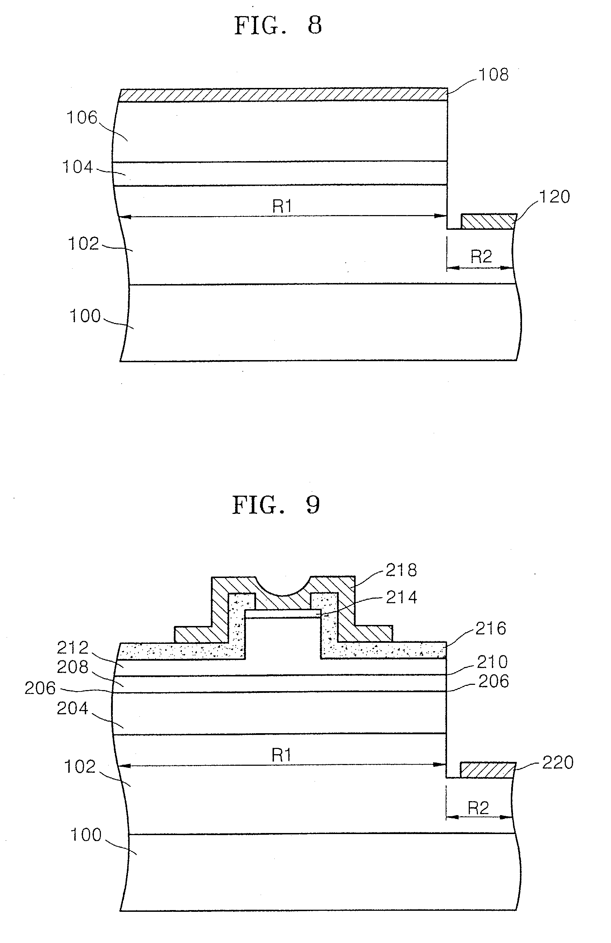

FIGS. 8 and 9 are cross-sectional views illustrating light emitting devices including the electrode layers according to the present invention. For example, FIG. 8 is a cross-sectional view of an LED including the electrode layer of FIG. 2 as a p-type electrode, and FIG. 9 is a cross-sectional view of an LD including the electrode layer of FIG. 2 as a p-type electrode.

Referring to FIG. 8, the LED includes an n-GaN layer 102 disposed on a substrate 100. The n-GaN layer 102 is divided into a first region R1 and a second region R2. There is a step difference between the first region R1 and the second region R2. The second region R2 is formed to a smaller thickness than the first region R1. An active layer 104, a p-GaN layer 106, and a p-type electrode 108 are sequentially formed on the first region R1 of the n-GaN layer 102. An n-type electrode 120 is formed on the second region R2 of the n-GaN layer 102.

Meanwhile, referring to FIG. 9, the LD includes an n-GaN layer 102 disposed on a substrate 100. The n-GaN layer 102 is divided into a first region R1 and a second region R2 like the LED shown in FIG. 5, and an n-type electrode 220 is formed on the second region R2. On top of the first region R1 of the n-GaN layer 102, an n-clad layer 204, an n-type waveguide layer 206 having a higher refractive index than the n-clad layer 204, an active layer 208 having a higher refractive index than the n-type waveguide layer 206, and a p-type waveguide layer 210 having a lower refractive index than the active layer 208 are sequentially formed. Also, a p-clad layer 212, which has a lower refractive index than the p-type waveguide layer 210, is formed on the p-type waveguide layer 210. A central upper portion of the p-clad layer 212 protrudes upward to form a ridge. A p-GaN layer 214 is formed as a contact layer on the protruding portion of the p-clad layer 212. An exposed surface of the p-clad layer 212 is covered by a protective layer 216, which also covers both outer portions of the p-GaN layer 214. A p-type electrode 218 is formed on the protective layer 216 to contact the exposed surface of the p-GaN layer 214.

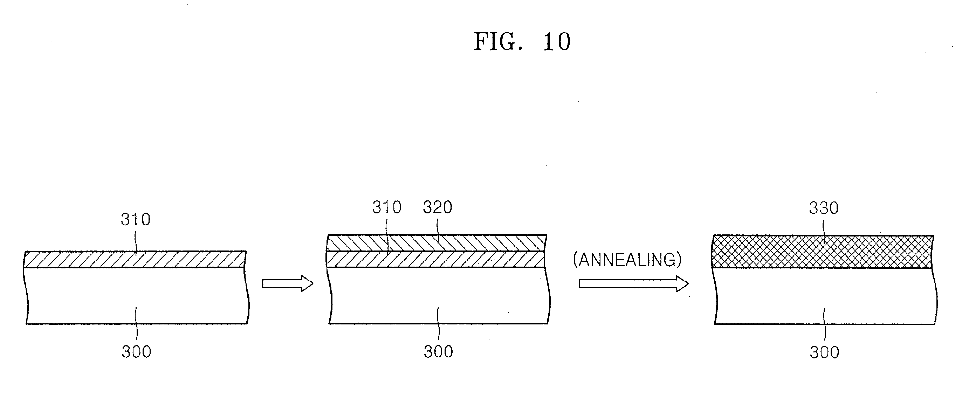

A method of manufacturing the electrode layer of FIG. 2 will now be described with reference to FIG. 10.

FIG. 10 illustrates a method of forming an electrode layer according to the present invention.

Referring to FIG. 10, a first electrode layer 310 is formed on a p-type compound semiconductor layer 300, for example, a p-type GaN layer. The first electrode layer 310 is formed by adding an additive element to indium oxide, for example, In₂O₃. The additive element may be at least one of Mg, Ag, Zn, Sc, Hf, Zr, Te, Se, Ta, W, Nb, Cu, Si, Ni, Co, Mo, Cr, Mn, Hg, Pr, and La. An addition ratio of the additive element to the indium oxide ranges from 0.001 to 49 atomic percent. The first electrode layer 310 may be formed to a thickness of 0.1 to 500 nm.

Thereafter, a second electrode layer 320 is formed on the first electrode layer 310 to a thickness of 0.1 to 500 nm. The second electrode layer 320 is a metal layer or a TCO layer. The metal layer may be formed of Au, Pd, Pt, or Ru. The TCO layer may be formed of ITO, ZITO, ZIO, GIO, ZTO, FTO, AZO, GZO, In₄Sn₃O₁₂, or Zn₁₋ₓMgₓO (0 ≤ x ≤ 1). The oxide layer may be, for example, a Zn₂In₂O₅ layer, a GaInO₃ layer, a ZnSnO₃ layer, an F-doped SnO₂ layer, an Al-doped ZnO layer, a Ga-doped ZnO layer, a MgO layer, or a ZnO layer.

The first and second electrode layers 310 and 320 can be formed using an electronic beam (e-beam) & thermal evaporator or a dual-type thermal evaporator. Also, the first and second electrode layers 310 and 320 can be formed by physical vapor deposition (PVD), chemical vapor deposition (CVD), or plasma laser deposition (PLD).

The first and second electrode layers 310 and 320 can be deposited at a temperature of about 20 to 1500°C under a reactor pressure of an atmospheric pressure to 10⁻¹² Torr.

After the second electrode layer 320 is formed, the resultant structure is annealed in an atmosphere of a gas including at least one of N, Ar, He, O, H, and air. The annealing process is performed at a temperature of about 200 to 700°C for 10 seconds to 2 hours.

During the annealing process, elements constituting the first and second electrode layers 310 and 320 may be mixed with one another so that a single electrode layer 330 may be formed on the p-type compound semiconductor substrate 300. Alternatively, the first and second electrode layers 310 and 320 may be separately formed on the p-type compound semiconductor substrate 300.

Hereinafter, experimental examples, which were conducted by the inventors in connection with the p-type electrode layer according to the present invention, will be described. A method of forming an electrode layer, which was conducted by the inventors, is not limited to the following exemplary processes.

At the outset, the surface of a structure, in which a p-type GaN-based compound semiconductor layer 300 is formed on a substrate, was washed in an ultrasonic bath at a temperature of 60°C using trichloroethylene (TCE), acetone, methanol, and distilled water, respectively, for 5 minutes each time. Then, the resultant structure was hard baked at a temperature of 100°C for 10 minutes to remove the remaining moisture from this sample.

Thereafter, a photoresist layer was spin-coated on the p-type compound semiconductor layer 300 at 4,500 RPM. The resultant structure was soft baked at a temperature of 85°C for 15 minutes. To develop a mask pattern, the sample was aligned with a mask, exposed to ultraviolet rays (UV) of 22.8 mW for 15 seconds, and dipped in a solution containing a mixture of a developing solution with distilled water in a ratio of 1: 4 for 25 seconds.

Thereafter, the developed sample was dipped in a buffered oxide etchant (BOE) solution for 5 minutes to remove a contaminated layer from the sample. Then, a first electrode layer 310 was formed on the resultant structure using an e-beam evaporator.

The first electrode layer 310 was deposited by mounting an object of reaction, which is formed by sintering a mixture of indium oxide with MgO in a ratio of 9: 1, on a mounting stage.

After the first electrode layer 310 was deposited, a second electrode layer 320 was deposited using Au, a lift-off process was carried out using acetone, and the sample was loaded into a rapid thermal annealing (RTA) furnace and annealed at a temperature of about 430 to 530°C for 1 minute. As a result, an electrode layer 330 was formed.

The foregoing method of forming the electrode layer can be applied to manufacture the light emitting devices shown in FIGS. 8 and 9.

As can be seen from the foregoing embodiment and experiment, the electrode layer of the present invention has a lower resistance and higher transmissivity than conventional electrode layers.

Also, unlike the conventional electrode layers, in which the thickness of a first electrode layer (a Ni layer) is limited below 10 nm due to high resistance and low transmissivity, a first electrode layer of the present invention can be formed to a greater thickness of about 0.1 to 500 nm. Thus, even if the first electrode layer is 100 nm thick, the electrode layer of the present invention can exhibit a low contact resistance and high transmissivity.

Therefore, when the electrode layer of the present invention is used for a light emitting device, the light emitting device can require only a low drive voltage and have a high transmissivity, thereby greatly improving a luminous efficiency.

While the present invention has been particularly shown and described with reference to exemplary embodiments thereof, it will be understood by those of ordinary skill in the art that various changes in form and details may be made therein without departing from the spirit and scope of the present invention as defined by the following claims. For example, an electrode layer of the present invention can applied to not only the light emitting devices shown in FIGS. 8 and 9 but also other light emitting devices and other devices requiring an electrode with a low resistance.

## Claims

1. An electrode structure including a first electrode layer and a second electrode layer, which are sequentially stacked,
wherein the first electrode layer is formed of indium oxide together with an additive element.

2. The electrode structure of claim 1, wherein the additive element includes at least one selected from the group consisting of Mg, Ag, Zn, Sc, Hf, Zr, Te, Se, Ta, W, Nb, Cu, Si, Ni, Co, Mo, Cr, Mn, Hg, Pr, and La.

3. The electrode structure of claim 2, wherein an addition ratio of the additive element to the indium oxide is in the range of 0.001 to 49 atomic percent.

4. The electrode structure of any preceding claim, wherein the thickness of the first electrode layer is in the range of 0.1 to 500 nm.

5. The electrode structure of any preceding claim, wherein the second electrode layer is a metal layer.

6. The electrode structure of claim 5, wherein the metal layer is formed of one selected from the group consisting of Au, Pd, Pt, and Ru.

7. The electrode structure of any of claims 1 to 4, wherein the second electrode layer is a transparent conductive oxide layer.

8. The electrode structure of claim 7, wherein the oxide layer is formed of one selected from the group consisting of ITO, ZITO, ZIO, GIO, ZTO, FTO, AZO, GZO, In₄Sn₃O₁₂, and Zn₁₋ₓMgₓO (0 ≤ x ≤ 1).

9. A light emitting device comprising at least an n-type compound semiconductor layer, an active layer, and a p-type compound semiconductor layer, which are disposed between an n-type electrode structure and a p-type electrode structure,
wherein the p-type electrode includes an electrode structure according to any preceding claim,
and the first electrode layer is formed of indium oxide added by an additive element.

10. A method of forming an electrode structure, the method comprising:
forming a first electrode layer on a substrate;
forming a second electrode layer on the first electrode layer; and
annealing the resultant structure where the second electrode layer is formed,
wherein the first electrode layer is formed of indium oxide added by an additive element.

11. The method of 10, wherein the additive element includes at least one selected from the group consisting of Mg, Ag, Zn, Sc, Hf, Zr, Te, Se, Ta, W, Nb, Cu, Si, Ni, Co, Mo, Cr, Mn, Hg, Pr, and La.

12. The method of claim 11, wherein an addition ratio of the additive element to the indium oxide is in the range of 0.001 to 49 atomic percent.

13. The method of claim 10, 11 or 12, wherein the first electrode layer is formed to a thickness of 0.1 to 500 nm.

14. The method of any of claims 10 to 13, wherein the second electrode layer is formed of a metal.

15. The method of claim 14, wherein the metal layer is formed of one selected from the group consisting of Au, Pd, Pt, and Ru.

16. The method of any of claims 10 to 13, wherein the second electrode layer is formed of a transparent conductive oxide.

17. The method of claim 16, wherein the oxide layer is formed of one selected from the group consisting of ITO, ZITO, ZIO, GIO, ZTO, FTO, AZO, GZO, In₄Sn₃O₁₂, and Zn₁₋ₓMgₓO (0 ≤ x ≤ 1).

18. The method of any of claims 10 to 17, wherein the annealing of the resultant structure is performed in an atmosphere including at least one selected from the group consisting of N, Ar, He, O, H, and air.

19. The method of any of claims 10 to 18, wherein the annealing of the resultant structure is performed at a temperature of about 200 to 700 °C for 10 seconds to 2 hours.

20. The method of any of claims 10 to 19, wherein the forming of the first electrode layer and the forming of the second electrode layer are performed using an e-beam & thermal evaporator.
